# EUROPEAN PATENT SPECIFICATION

(11) **EP 3 652 857 B1**
(45) Date of publication and mention of the grant of the patent: **30.06.2021**
(21) Application number: 18737297.4
(22) Date of filing: 12.07.2018
(51) Int. Cl.: H03K 17/12, H03K 17/16, H03K 17/06

(54) **POWER SEMICONDUCTOR MODULE GATE DRIVER WITH INPUT COMMON MODE CHOKE**
LEISTUNGSHALBLEITERMODUL-GATTERTREIBER MIT EINGANGSGLEICHTAKTDROSSEL
MODULE SEMI-CONDUCTEUR DE PUISSANCE PILOTE DE GRILLE À BOBINE D'ARRÊT EN MODE COMMUN D'ENTRÉE

(30) Priority: 13.07.2017 EP 17181103
(43) Date of publication of application: 20.05.2020
(73) Proprietor: ABB Schweiz AG, 5400 Baden (CH)
(72) Inventor: ALVAREZ, Silverio, 5405 Baden Dättwil (CH); TRAUB, Felix, 5413 Birmenstorf (CH); ORTIZ, Gabriel, 8005 Zürich (CH)
(74) Representative: Qip Patentanwälte Dr. Kuehn & Partner mbB
(86) International application number: PCT/EP2018/068930
(87) International publication number: WO 2019/012038

(56) References cited:
- EP-A1- 1 292 027
- US-A1- 2008 297 964
- US-A1- 2009 027 937
- US-B2- 7 969 208

## Description

### FIELD OF THE INVENTION

The invention relates to a power semiconductor unit and a power semiconductor unit arrangement.

### BACKGROUND OF THE INVENTION

Power semiconductor modules are designed for a specific maximum current rating, which is typically limited by semiconductor and module characteristics, and are oftentimes defining the maximum achievable power rating of the power electronics converter. Paralleling of power semiconductor modules is an effective way of increasing this power rating while using the same module, offering several benefits in terms of standardization and flexibility in the design of a power electronics converter. In the ideal case, these power semiconductor modules can be seamlessly paralleled, provided that their electrical characteristics are perfectly matched. In the real case, however, the power semiconductor modules do not possess perfectly matched characteristics and/or a power electronics building block hosting these power semiconductor modules is not constructed in a perfectly symmetrical manner. These and other non-idealities lead to undesired asymmetries in the loading of the paralleled devices, since identical switched currents and switching processes cannot be ensured. Furthermore, these non-idealities can lead to instabilities in the gate signals of the paralleled power semiconductor modules, compromising the correct operation of the power semiconductors.

One possibility to account for these issues is to introduce a derating for interconnected power semiconductor modules and therefore a reduction in the potential capacity of the power electronics converter. This is the most traditionally used technique which is based on introducing a derating factor to the nominal power semiconductor module current rating in order to compensate for non-idealities in the characteristics and layout asymmetries. This effectively results in a less-than-linear scaling of the rating of the power electronics converter with respect to the number of paralleled power semiconductor modules. This derating factor is typically in the 10-20% range depending on number of paralleled power semiconductor modules.

The main drawback of this approach may be the under-utilization of capacity of the power semiconductor modules, resulting in an increased cost of the power electronics converter. In addition, in cases when the parameters of the power semiconductor modules are unmatched and/or the electrical layout is not symmetric, this method may not provide stabilization of the gate signals during the switching transients, leading to potential violation of the safe operating area of the power semiconductor modules. Furthermore, asymmetries in the gate connection distribution from the gate driver circuit may cause further asymmetries in the switching performance of the power semiconductor modules.

A further approach may be to use common and/or differential mode chokes between the gate driver circuit and the gate of the power semiconductor, as shown in US 2006/0226708 A1. This approach may accomplish the stabilization of the gate signals, ensuring operation within the safe operation area and, under certain conditions, it may improve the dynamic sharing of current during the switching transient, leading to more symmetric sharing of switching losses among the power semiconductor modules and hence to lower deratings.

The main drawback of these approaches may be seen in a stringent requirement of a leakage inductance of the common and differential mode chokes, as high values of leakage inductance lead to undesired resonances in the gate path. In addition, the current between the gate driver circuit and the gate of the power semiconductor is usually characterized by repetitive high peaks, resulting in high averaged (such as rms, root mean square) current rating of the chokes. All these factors usually negatively impact the value of a common mode (main) inductance and impose restrictions on the design of the common mode choke which are complex to fulfill simultaneously.

Furthermore, it is possible to actively parallel the power semiconductor modules, as shown in US2012/0098677 A1, i.e. to generate independent gate signals for the power semiconductor modules. With active paralleling, all non-idealities in the characteristics and asymmetries in the interconnection layout may be overcome. The gate signal of each paralleled semiconductor may be adapted in order to equalize the switching losses among the paralleled power semiconductor modules. To do this, the emitter or collector current of each power semiconductor switch may be measured and this measurement may be fed back to a controller, which takes corrective actions in case the switching transitions are not symmetric. A common method to adapt the gate signals is to introduce a time delay between them, compensating for non-idealities in the modules' characteristics and/or for layout asymmetries. This method may result in paralleled power semiconductor modules, where each paralleled semiconductor is driven by its own dedicated controller stage.

A drawback of this solution may be a requirement of high bandwidth and isolated current measurement of the emitter currents in each paralleled power semiconductor module. Furthermore, gate signals for each of the paralleled power semiconductor modules may have to be generated independently, leading to higher requirements in the digital signal processor responsible for the gate signal generation. Additionally, since the switching transients may occur in the 100 ns range, the resolution in the delay time of the gate signal may have to be considerably high, imposing stringent requirements in the gate signal generator.

US 2008/297 964 A1 shows a power supply device, which comprises an amplifier for providing a gate signal to a semiconductor switch. The gate signal supplied to the amplifier and a ground potential are inductively coupled with a choke. A positive voltage supplied to the amplifier and the ground potential are inductively coupled with a further choke.

US 7 969 208 B2 shows a control circuit for a power semiconductor switch, in which three power supply terminals for an amplifier for amplifying a gate signal are inductively coupled with a choke having a common core.

### DESCRIPTION OF THE INVENTION

It is an objective of the invention to overcome or at least mitigate the above mentioned drawbacks. It is a further objective of the invention to provide a simple and effective solution to lower the switching losses of paralleled power semiconductor modules.

These objectives are achieved by the subject-matter of the independent claims. Further exemplary embodiments are evident from the dependent claims and the following description.

An aspect of the invention relates to a power semiconductor unit. The power semiconductor unit may be any device that mechanically and electrically interconnects one or more power semiconductor chips and their electrical interconnections. Usually, a power semiconductor unit comprises a housing for accommodating the one or more power semiconductor chips and/or their electrical interconnections, which housing also may provide inputs for electrical interconnecting the power semiconductor unit with other power semiconductor units and/or, for example, the circuitry of a power semiconductor device, such as a rectifier or inverter.

The parts of the power semiconductor unit with the one or more power semiconductor chips and their electrical interconnections (which may form a power circuit) may be seen as a power semiconductor module. The power semiconductor unit may additionally comprise an auxiliary circuit, which may be mechanically integrated with the power semiconductor module.

According to the embodiment of the invention, the power semiconductor unit comprises a power semiconductor switch adapted for switching a current through power semiconductor unit terminals. A power semiconductor switch may be a thyristor or transistor such as an IGBT, MOSFET, etc.

The power semiconductor switch comprises a positive power input, a negative power input and a gate. The positive power input may be a collector (for example for an IGBT) or a drain (for example for a MOSFET). The negative power input may be an emitter (for example for an IGBT) or a source (for example for a MOSFET).

The power semiconductor switch may refer to one or more power semiconductor chips, which are mechanically and electrically interconnected within the power semiconductor unit and to the electrical circuit through terminals of the power semiconductor unit.

It has to be noted that a term "power" here and in the following may refer to devices adapted for processing voltages of more than 100 V and/or 10 A. For example, a voltage rating for the power semiconductor switch used in the power semiconductor unit may range between 600V and 10 kV.

Furthermore, the power semiconductor unit may comprise more than one power semiconductor switch. For example, the power semiconductor unit may comprise two series connected power semiconductor switches, which for example may form a half bridge.

The one or more power semiconductor switches of the power semiconductor unit form a power circuit that may be connected via power inputs that may be provided by a housing of the power semiconductor unit, with other power devices, such as devices in order to form a power conversion function (e.g. DC/AC, DC/DC, AC/DC, AC/AC). For example, the power semiconductor unit may comprise two power inputs for the current switched by the power semiconductor switch.

Besides the power circuit, the power semiconductor unit also may comprise an auxiliary circuit that may be responsible for generating measurement values inside the power semiconductor unit, such as specific voltages, currents and/or temperatures. Furthermore, the auxiliary circuit may be responsible for generating a gate voltage that is applied to a gate of the power semiconductor switch and/or that controls the switching state of the power semiconductor switch, i.e. whether it is in a blocking state or a conducting state. There also may be auxiliary inputs of the power semiconductor unit, which also may be provided by a housing of the power semiconductor unit, which are electrically interconnected with parts of the auxiliary circuit.

According to the embodiment of the invention, the power semiconductor unit furthermore comprises a gate driver circuit for receiving a gate signal from a gate signal input and for connecting the gate of the power semiconductor switch with a positive voltage reference from a positive voltage input. The gate signal, which may be an on-and-off-signal, the positive voltage reference, which may be constant voltage signals for example at +15 V, may be provided by a controller of the power device, the power semiconductor unit is a part of.

According to the embodiment of the invention, the power semiconductor unit furthermore comprises a positive power reference input connected with the positive power input and a negative power reference input connected with the negative power input.

The potential of the negative power reference input may be used as controller reference potential and/or may have a voltage of 0 V per definition. With the positive power reference input, the controller may measure a voltage difference across the power semiconductor switch, for example.

The gate driver circuit furthermore may comprise an energy storage to separate the gate signal from the actual energy needed to switch the power semiconductor switch.

According to the embodiment of the invention, the power semiconductor unit furthermore comprises a common mode coupling device for providing an impedance for a common mode current through auxiliary inputs of the power semiconductor unit. The auxiliary inputs may comprise the gate signal input, the positive voltage input, the positive power reference input and the negative power reference input.. In other words, the common mode coupling device may be placed before the gate driver circuit, i.e. on the supply and signal input lines of the gate driver circuit and/or before auxiliary terminals for connection to these lines.

In general, the common mode coupling device may be any device providing a high impedance for common mode currents flowing in the electrical connections between the auxiliary terminals, the gate driver circuit and the main (i.e. central) driving circuit, which may be provided by the above-mentioned controller.

In particular, the common mode coupling device comprises a common mode choke with a (single) core coupling the auxiliary inputs. For each electrical line, the common mode choke may comprise an inductance and/or a winding which is inductively coupled with the other inductances and/or windings of the common mode choke. The common mode choke may be placed in the signal and power supply lines, which are interconnecting the auxiliary inputs with the amplifier. In the present case, the common mode choke may comprise four or more inductances and/or windings. The inductances and/or windings of the common mode choke may be inductively coupled via a single core, which may be seen as a common core, i.e. a core onto which all windings are provided. This may increasing the coupling between all auxiliary inputs.

In general, the current through the auxiliary inputs may be seen as a multi-pole current. A common mode current may be seen as the average of the sum of the pole currents, i.e. the current through the auxiliary inputs. This common mode current may be limited and/or reduced by the common mode coupling device. The impedance of the common mode coupling device may be an impedance for damping a time derivative of the common mode current. Thus, the impedance may damp the common mode voltage of the common mode current.

The inputs may be seen as auxiliary inputs and/or may be provided by auxiliary terminals, which may be provided on a housing of the power semiconductor unit. The common mode coupling device is thus electrically interconnected between these inputs and further parts of the gate driver circuit adapted for switching the gate voltage supplied to the power semiconductor switch.

With the common mode coupling device, the dynamics of current sharing between different power semiconductor units as described herein during switching transients may be improved. This may lead to a more symmetric sharing of switching losses among the power semiconductor units. Due to the placing of the common mode coupling device in front of the gate driver circuit, the design of the common mode coupling device may be greatly relaxed, since DC currents, opposed to repetitive high current pulses, only may have to be conducted by the common mode coupling device. Thus, a large leakage inductance and/or low root mean square current capability may be acceptable. This in turn may lead to large values of main inductance and therefore may lead to an improved paralleling performance.

Connecting the common mode coupling device before the switching part and/or amplifier of the gate driver circuit may have several advantages. An impact of the leakage inductance of the common mode coupling device in the switching performance may be negligible, as ideally only DC and/or comparatively low amplitude currents flow through the common mode coupling device. This may enable to select a considerably high value of common mode inductance without impacting the switching behaviour. Furthermore, the root mean square current conducted by the common mode coupling device may be considerably reduced, leading to smaller component dimensions.

Additionally, the gate inductance of the power semiconductor unit may be considerably reduced and controlled, which may increase the speed and controllability on the device while minimizing risks of overvoltages due to gate resonances.

By using the power semiconductor unit several times, the gate circuit designs of paralleled power semiconductor units may be symmetrized, since all power semiconductor units may be equipped with an amplification stage of the same design.

The proposed design may be an enabler for a gate drive design using active paralleling by delay time compensation. Specifically, as long as the delays of paralleled power semiconductor units do not become arbitrarily large, the resulting voltage differences do not need to be handled by output stages with independent gate signals, but rather by the common mode coupling device in the gate path.

It has to be noted that the design of the gate driver circuit with the common mode coupling device before the other parts of the gate driver circuit may result in a higher complexity, higher component count and/or a higher space requirement. Also, a testing due to the requirement of active components may be additionally required.

According to the embodiment of the invention, the common mode coupling device is interconnected between the auxiliary inputs and an amplifier for connecting the gate of the power semiconductor switch with the positive voltage. The amplifier may be the part of the gate driver circuit, which is adapted for connecting the gate of the power semiconductor switch with the positive voltage reference based on the gate signal. The auxiliary inputs of the power semiconductor may be connected via the common mode coupling device to the amplifier and the amplifier may be connected to the gate of the power semiconductor switch.

It also may be possible that the common mode coupling device comprises at least two common mode chokes with at least two cores, each core coupling at least two auxiliary inputs. A high common mode impedance also may be generated by appropriately connecting several two- or multi-line common mode chokes. The windings of the common mode chokes may be coupled in such a way that the assembly of cores produces effectively a common mode impedance for the auxiliary inputs.

According to the embodiment of the invention, the gate driver circuit is adapted for connecting the gate of the power semiconductor switch with a further (such as negative or zero) voltage reference from a further (such as negative or zero) voltage input as a further auxiliary input. The common mode coupling device is adapted for providing an impedance for a common mode current through the auxiliary inputs including the further voltage reference. To account for, for example normally-on devices, the positive and the further voltage reference may be two different voltage levels for turning-on and turning-off the power semiconductor switch. However, the further voltage reference may be a negative voltage reference, which may be a constant voltage signals for example at -15 V The further voltage reference signal may be provided by a controller of the power device, the power semiconductor unit is a part of.

According to an embodiment of the invention, the gate driver circuit comprises at least one gate resistor interconnected between the amplifier for receiving the gate signal, the positive voltage reference and optionally the negative voltage reference and for supplying a gate of the power semiconductor switch. The gate driver circuit also may comprise a diode connected in series with a gate resistor, such that a gate resistance dependent on the sign of the voltage applied to the gate may be provided. In general, the gate driver circuit may comprise passive circuitry such as gate resistors and/or capacitors.

Furthermore, the gate driver circuit may act like a voltage or a current source or a combination of both.

According to an embodiment of the invention, the amplifier of the gate driver circuit is adapted for controlling a current supplied to the gate of the power semiconductor switch. Instead of directly connecting to the positive and/or the negative reference voltage, the amplifier may have a continuous analog voltage output, which may be used to control the current to the gate, which may flow via the one or more gate resistors, to a defined set-point. This way a fixed current may be ensured during the turn-on/off transients as opposed to an amplifier acting as a voltage source, where the current may be only limited by the one or more gate resistors.

According to an embodiment of the invention, the gate driver circuit comprises a reference resistor interconnected between the negative power reference input and the negative power input of the power semiconductor switch. The gate driver circuit may comprise a further reference resistor interconnected between the positive power reference input and the positive power input of the power semiconductor switch.

The positive power reference input may be different from the positive voltage input. The negative power reference input may be different from the negative voltage input.

The positive and/or negative power reference inputs may be used for providing a positive and/or negative power reference potential to a controller which provides the gate signal to the gate driver circuit. It has to be noted that also these reference inputs run through the common mode coupling device and are inductively coupled with the other auxiliary inputs.

A further aspect of the invention relates to a power semiconductor unit arrangement, which comprises at least two power semiconductor units as described in the above and in the following. The power inputs of the at least two power semiconductor units are connected in parallel with each other. In such a way, the power semiconductor unit arrangement may be a parallel connection of power semiconductor units, which is adapted for processing a multiple of the current that may be processed by only one power semiconductor unit.

Two or more power semiconductor units may be interconnected via their respective power terminals of power inputs. Furthermore, each power semiconductor unit may be equipped with a gate driver circuit.

The power semiconductor units, which are paralleled by their power inputs, may be provided with gate signals in different ways. In general, it may be possible that the power semiconductor units are supplied by the same gate signal or are supplied with different gate signals that may be generated by different controllers.

According to an embodiment of the invention, the gate signal inputs of the at least two power semiconductor units are connected with each other. The independent gate driver circuits of the power semiconductor units may be commanded by the same gate signal by also paralleling the power semiconductor units on the auxiliary side. For example, the gate signal may be generated by a higher level controller, which also may supply the positive and negative voltage reference to gate driver circuits of the paralleled power semiconductor units.

According to an embodiment of the invention, the gate signal inputs are connected to one or more controllers adapted for generating gate signals for the at least two power semiconductor units, which gate signals are time-shifted with respect to each other.The independent gate driver circuits of the power semiconductor units may be commanded by independent gate signals, which may be generated by one or more higher level controllers. For example, every power semiconductor unit may comprise a higher level controller of its own.

The one or more higher level controllers may receive measurement values of voltages and/or currents inside the respective power semiconductor unit and may generate the gate signal dependent on these measurements. In such a way, it may be that the independent gate signals are shifted in time with respect to each other.

According to an embodiment of the invention, the positive voltage reference inputs of the at least two power semiconductor units are connected with each other, the negative voltage reference inputs of the at least two power semiconductor units are connected with each other and/or the negative power reference inputs of the at least two power semiconductor units are connected with each other. Also, the positive power reference inputs of the at least two power semiconductor units may be connected with each other. For example, one higher level controller may be connected to these paralleled auxiliary inputs. However, it also may be possible, that every power semiconductor unit is controlled by a dedicated higher level controller, which also is interconnected with the positive and negative power reference inputs of the respective power semiconductor unit and which provides the positive voltage reference, the negative voltage reference and the gate signal for this power semiconductor unit.

These and other aspects of the invention will be apparent from and elucidated with reference to the embodiments described hereinafter.

### BRIEF DESCRIPTION OF THE DRAWINGS

The subject-matter of the invention will be explained in more detail in the following text with reference to exemplary embodiments which are illustrated in the attached drawings.
Fig. 1 schematically shows a power semiconductor unit arrangement.
Fig. 2 schematically shows a power semiconductor unit arrangement.
Fig. 3 schematically shows a power semiconductor unit arrangement.
Fig. 4 schematically shows a power semiconductor unit arrangement according to an embodiment of the invention.
Fig. 5 schematically shows a common mode coupling device for a power semiconductor unit.
Fig. 6A shows a diagram with gate signals and collector currents for a conventional power semiconductor unit arrangement during a turn off transient.
Fig. 6B shows a diagram analogously to Fig. 6A for a power semiconductor unit arrangement according to a further embodiment of the invention.
Fig. 7A shows a diagram with gate signals and currents for a conventional power semiconductor unit arrangement during a turn on transient.
Fig. 7B shows a diagram analogously to Fig. 6A for a power semiconductor unit arrangement according to a further embodiment of the invention.
Fig. 8A, 8B, 9A and 9B show diagrams with gate signals and currents for a power semiconductor unit arrangement according to a further embodiment of the invention.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

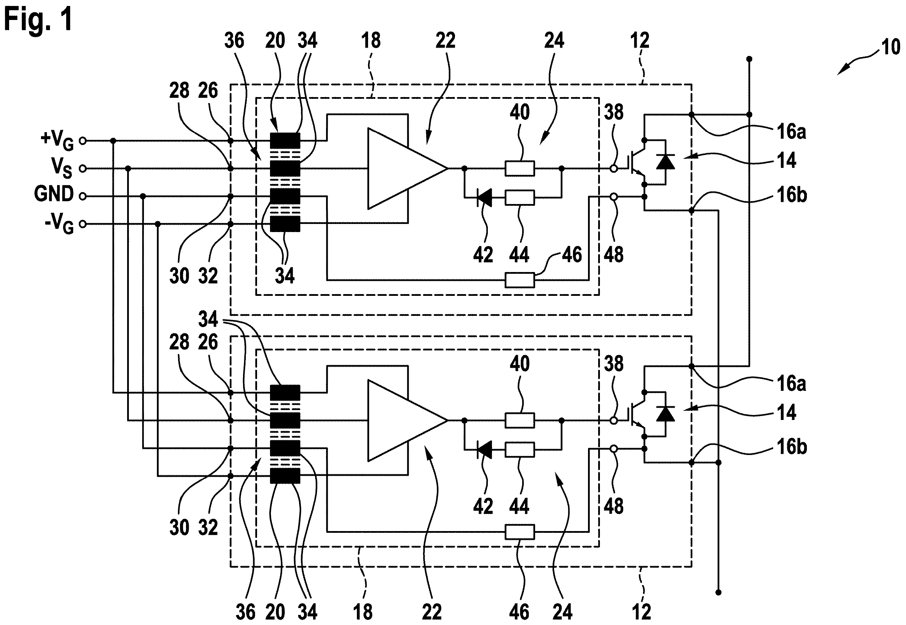

Fig. 1 shows a power semiconductor unit arrangement 10 comprising two power semiconductor units 12 that on a power side are connected in parallel.

Every power semiconductor unit 12 comprises a power semiconductor switch 14 that provides two power inputs 16a, 16b, which also may be seen as power inputs 16a, 16b of the power semiconductor unit 12. The positive power input 16a of the one semiconductor unit 12 is interconnected with the positive power input 16a of the other semiconductor unit 12. Analogously, the negative power input 16b of the one semiconductor unit 12 is interconnected with the negative power input 16b of the other semiconductor unit 12.

As shown in Fig. 1, the power semiconductor switch 14 may comprise an IGBT connected in parallel with a freewheeling diode. However, it is also possible that the power semiconductor switch 14 comprises an IGBT, MOSFET or other type of switching element.

The gate of the power semiconductor switch 14 is supplied by gate driver circuit 18 that comprises a common mode coupling device 20, an amplifier 22, and the gate resistance 24. Other elements such as gate driver capacitors, protective elements, etc. may also be integrated in the gate driver circuit 18 but are omitted in this description

At an auxiliary side of the power semiconductor unit 12, the gate driver circuit 18 is connected via four auxiliary inputs 26, 28, 30, 32 to an outside of the respective power semiconductor unit 12. A gate signal Vs is provided via the gate input 28, a positive voltage reference +VG is provided via the input 26, a negative voltage reference -VG is provided via the input 32 and a controller reference potential GND may be provided via the negative power reference input 30.

The common mode coupling device 20 is interconnected in the lines, which connect the inputs 26, 28, 32 with the amplifier 22 and the line, which connects the negative power reference input 30 with the negative power input 16b of the power semiconductor switch 14.

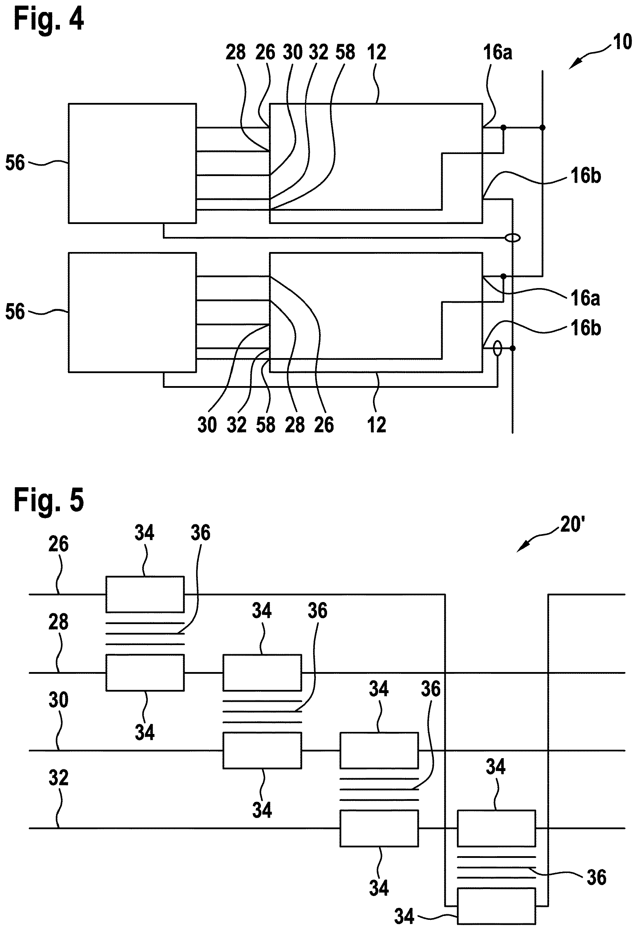

Also, a positive power reference input 58 as auxiliary input is provided at the auxiliary side of the power semiconductor unit 12 (see Fig. 4). The positive power reference input 58 is connected with the positive power input 16a of the power semiconductor switch 14. The common mode coupling device 20 is also interconnected in the line, which connects the positive power reference input 58 with the positive power input 16a of the power semiconductor switch 14.

As shown in Fig. 1, the common mode coupling device 20 is a common mode choke which comprises four or more windings 34 in each of these lines, which are coupled via one, common core 36.

The amplifier 22 is adapted for connecting the gate 38 of the power semiconductor switch 14 with the positive voltage reference +VG and negative voltage reference -VG based on the gate signal Vs. For example, when the gate signal Vs is positive, then the amplifier 22 connects the gate 38 to the positive voltage reference +VG and when the gate signal Vs is negative, then the amplifier 22 connects the gate 38 to the negative voltage reference -VG.

The output of the amplifier 22 may be connected via a gate resistance 24 with the gate 38. The gate resistance 24 may comprise a gate resistor 40 connected in parallel with series connection of diode 42 and a further gate resistor 44. This makes it possible to provide a gate resistance 24 that depends on the side of the voltage supplied to the gate 38.

The controller reference potential GND may be provided via a reference resistor 46 which is interconnected between the negative power reference input 30 and the emitter or source 48 of the power semiconductor switch 14, i.e. the negative power input 16b.

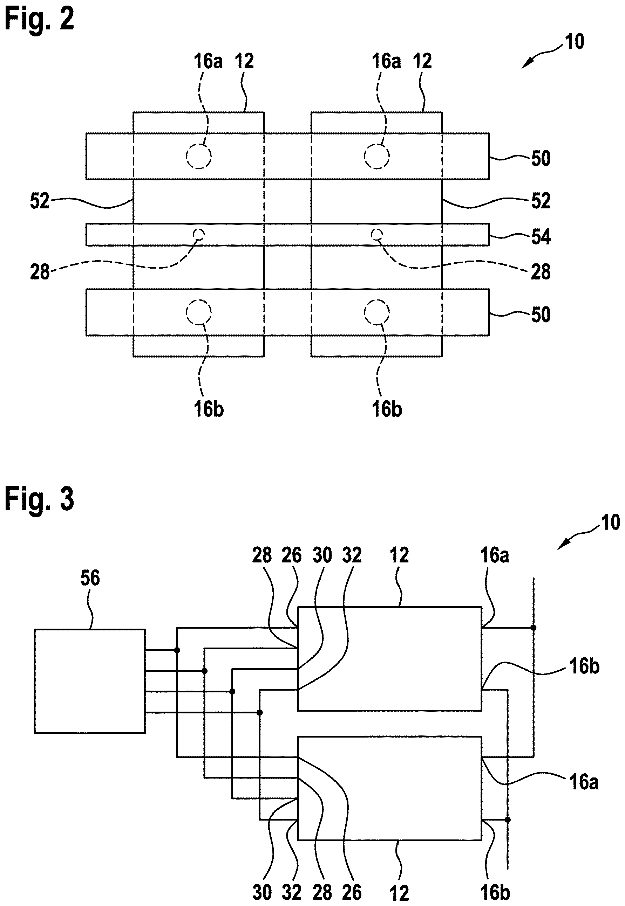

Fig. 2 shows that the power semiconductor units 12 may be paralleled with the aid of busbars 50 that electrically interconnect the power inputs 16a, 16b. The busbars 50 may be connected to the power inputs or terminals 16a, 16b that may be provided on a housing 52 of the respective power semiconductor unit 12.

Fig. 2 furthermore shows, that also the gate inputs 28 may be connected in parallel with a further electrical interconnection 54. As will be explained below, the arrangement of common mode coupling device 20 and amplifier 22 within every power semiconductor unit 12 may reduce the influence of the design and the interconnection of the electrical interconnection 54 with a higher level controller.

Fig. 3 shows how the power semiconductor unit arrangement 10 of Fig. 1 may be interconnected with higher level controller 56. The auxiliary inputs 26, 28, 30, 32 of the power semiconductor units 12 may be connected in parallel with each other and these paralleled inputs 26, 28, 30, 32 may be connected with the higher level controller 56. In this arrangement, the higher level controller 56 may provide the positive and negative voltage references VG, -VG and a common gate signal Vs for both power semiconductor units 12.

Fig. 4 shows a power semiconductor unit arrangement 10, which comprises two independent higher level controllers 56. In Fig. 4, every power semiconductor unit 12 is interconnected with different higher level controller 56, which provides the positive and negative voltage references VG, -VG and a dedicated gate signal Vs for its respective power semiconductor unit 12.

As shown in Fig. 4, each higher level controller 56 may measure an emitter and/or collector current of the respective power semiconductor unit 12 and may generate the gate signal Vs dependent on these measurements. In such a way, the gate signals Vs for the power semiconductor units 12 may be time shifted with respect to each other.

Fig. 4 also shows that the power semiconductor unit 12 comprises a positive power reference input 58, which is connected with positive power input 16a of the power semiconductor switch 14. This positive power reference input 58 is coupled to the other auxiliary inputs 26, 28, 30, 32 with the common mode coupling device 20.

Fig. 5 shows an example of a common mode coupling device 20' that comprises several cores 36, which interconnect inductances or windings 34 interconnected into the lines of the auxiliary inputs 26, 28, 30, 32. In particular, in Fig. 4, the common mode coupling device 20' comprises four (in general a plurality of) two-phase common mode chokes, each of which comprises solely two windings 34. Each of these two-phase common mode chokes couples solely two of the auxiliary inputs 26, 28, 30, 32, which, however, are all coupled with each other indirectly. It may be possible that the common mode coupling device 20' comprises so many common mode chokes that each possible pair of auxiliary inputs 26, 28, 30, 32 is coupled by one of the common mode chokes. It also may be possible that the common mode coupling device 20' comprises so many common mode chokes that each possible pair of auxiliary inputs 26, 28, 30, 32 except one is coupled by one of the common mode chokes.

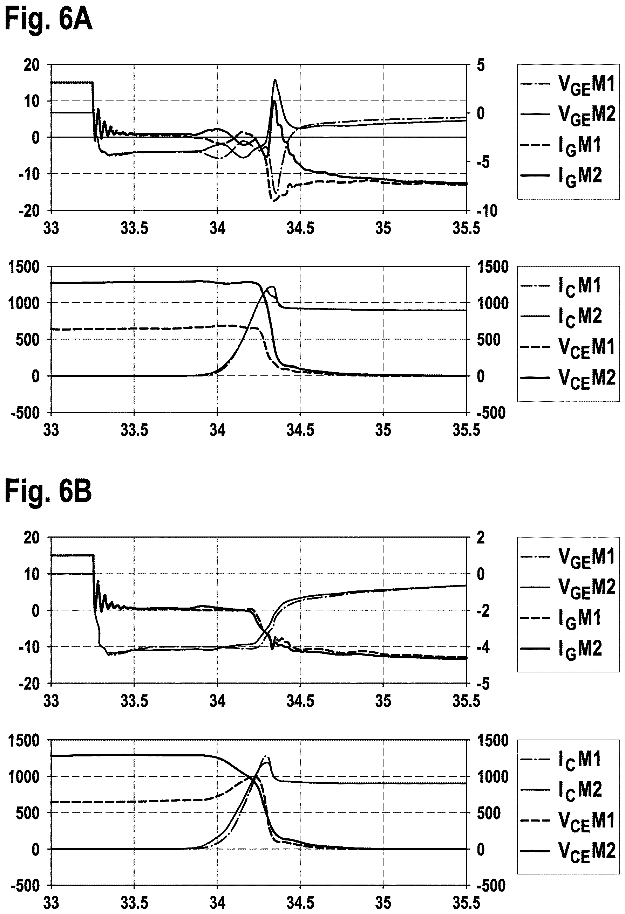

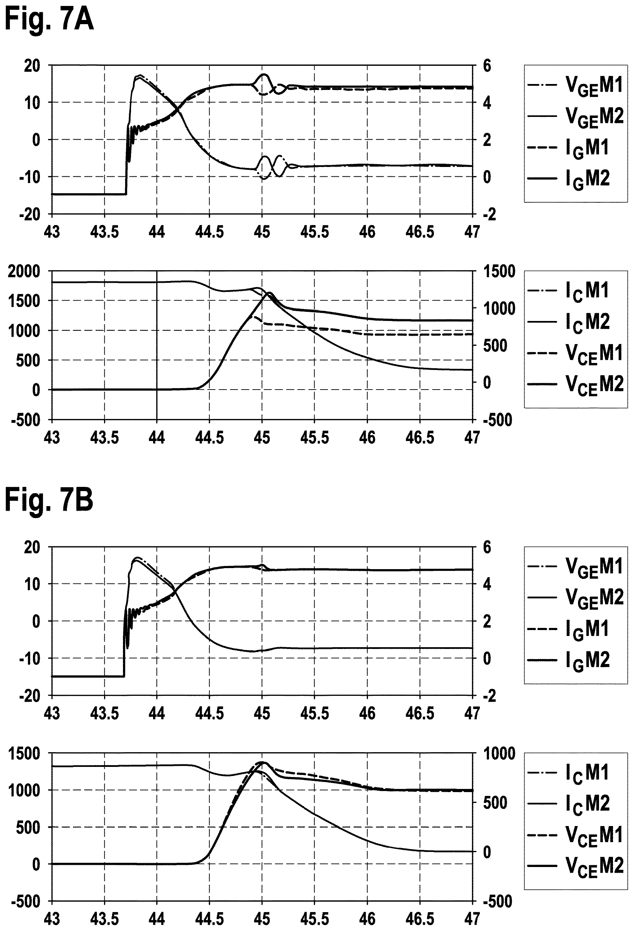

Fig. 6A, 6B, 7A and 7B show gate signals (upper diagram) and collector waveforms (lower) diagram during turn-off (Fig. 6A, 6B) and during turn-on (Fig. 7A, 7B).

The upper diagrams show the gate emitter voltages V_{GE}M1, V_{GE}M2 as well as the gate currents I_{G}M1, I_{G}M2 for a first and second power semiconductor unit. The lower diagrams show the collector emitter voltages V_{CE}M1,V_{CE}M2 as well as the collector currents I_{C}M1, I_{C}M2 of the first and second power semiconductor unit.

All quantities shown in the diagrams of Fig. 6A to 7B are depicted via time in microseconds to the right.

Fig. 6A and Fig. 7A show the waveforms for a power semiconductor arrangement as shown in Fig. 1, but without the common mode coupling device 20. It can be seen that the gate waveforms V_{GE}M1, V_{GE}M2, I_{G}M1, I_{G}M2 comprise resonances and that the turned-off or turned on currents I_{G}M1,I_{G}M2 are significantly asymmetric, resulting in an asymmetric switching loss distribution.

Fig. 6B and Fig. 7B show the waveforms for a power semiconductor arrangement as shown in Fig. 1, however, together with the common mode coupling device 20. Here, considerably more stable gate waveforms V_{GE}M1, V_{GE}M2, I_{G}M1, I_{G}M2, especially during the turn-off transition, can be seen. The gate signals always may be kept within a safe operating area. Moreover, the non-equally distributed currents I_{C}M1, I_{C}M2 previous to the turn-off instant (see Fig. 6B, lower diagram), for example caused by an asymmetric AC connection, do not result in an asymmetric switching loss distribution, since the currents I_{C}M1, I_{C}M2 are considerably equalized before the turn-off process takes place, leading to more symmetric loading of the semiconductor switches. The behaviour is similar for the turn-on process.

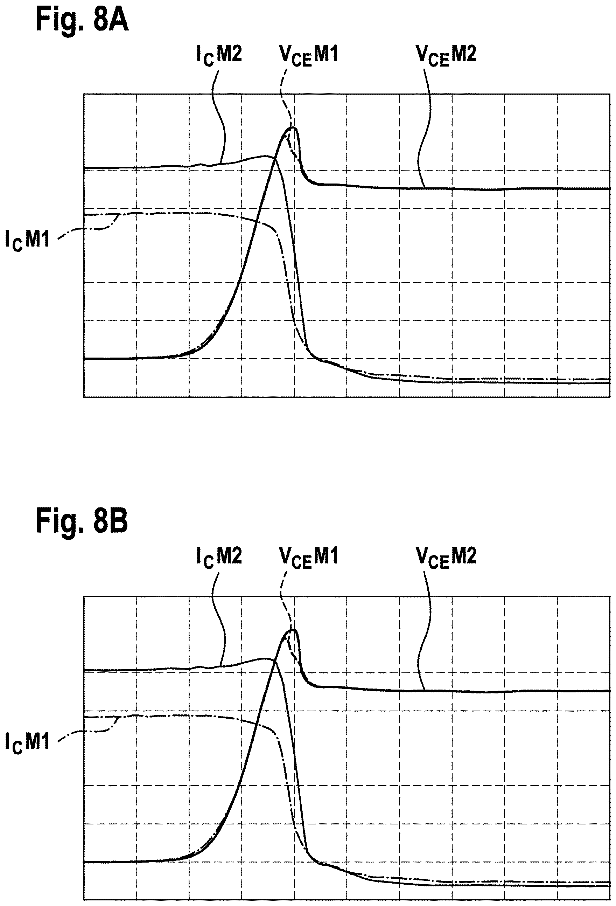

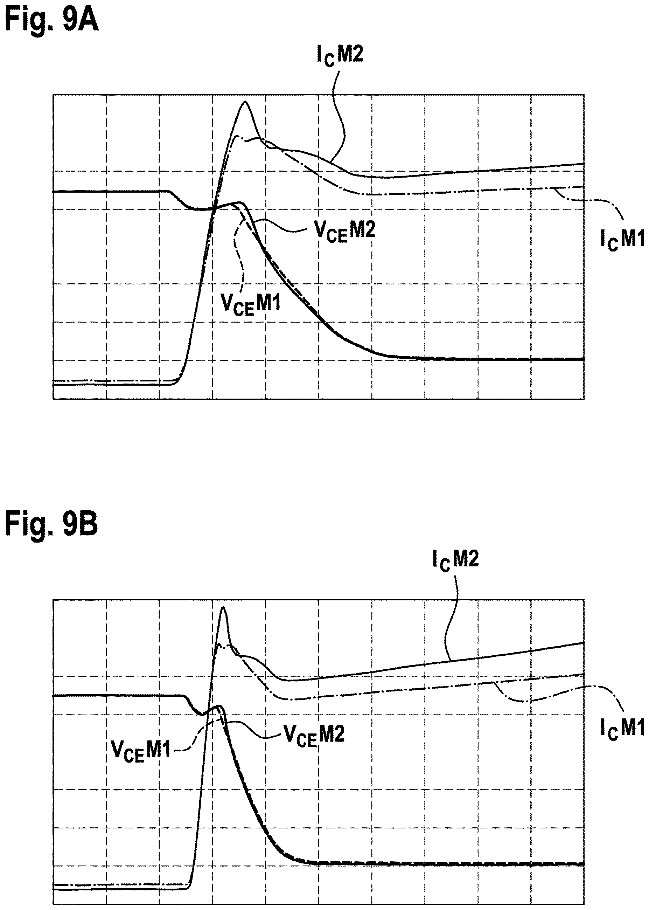

Fig. 8A, 8B, 9A, 9B compare the effect of the common mode coupling device 20 in view of an asymmetric gate connection, as may be possible in Fig. 2. Fig. 8A and 9A show the behaviour of the arrangement 10, when the controller 56 is electrically connected to the left of the electrical interconnection 54. Fig. 8B and 9B show, when the controller is electrically connected to the right of the electrical interconnection 54.

Fig. 8A and 8B show the behaviour of the arrangement 10 under turn-off, Fig. 9A and 9B under turn-on. All Figs. 8A to 9B show collector emitter voltages V_{CE}M1, V_{CE}M2 and collector currents I_{C}M1, I_{C}M2 of two power semiconductor units 12 as shown in Fig. 2 with a common mode coupling device 20.

By comparing Fig. 8A with 8B (turn-off) and Fig. 9A with 9B (turn-on), it can be seen that there is only a negligible impact of asymmetries in the gate signal connection in the performance of the parallel connection, due to the well-controlled and nearly identical parasitics in the gate connection for each power semiconductor unit 12, which are achieved by the common mode coupling device 20.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 10: power semiconductor unit arrangement
- 12: power semiconductor unit
- 14: power semiconductor switch
- 16a, 16b: power input
- 18: gate driver circuit
- 20, 20': common mode coupling device
- 22: amplifier
- 24: gate resistance
- +VG: positive voltage reference
- Vs: gate signal
- GND: controller reference potential
- -VG: negative voltage reference
- 26: input for positive voltage reference +VG
- 28: input for gate signal Vs
- 30: negative power reference input
- 32: input for negative voltage reference -VG
- 34: winding
- 36: core
- 38: gate
- 40: gate resistor
- 42: diode
- 44: gate resistor
- 46: controller reference resistor
- 48: emitter/source
- 50: busbar
- 52: housing
- 54: electrical interconnection
- 56: higher level controller
- 58: positive power reference input
- V_{GE}M1: gate emitter voltage of first power semiconductor unit
- V_{GE}M2: gate emitter voltage of second power semiconductor unit
- I_{G}M1: gate current of first power semiconductor unit
- I_{G}M2: gate current of second power semiconductor unit
- V_{CE}M1: collector emitter voltage of first power semiconductor unit
- V_{CE}M2: collector emitter voltage of second power semiconductor unit
- I_{C}M1: collector current of first power semiconductor unit
- I_{C}M2: collector current of second power semiconductor unit

## Claims

1. A power semiconductor unit (12), comprising:
a power semiconductor switch (14) adapted for switching a current through the power semiconductor unit (12), the power semiconductor switch comprising a positive power input (16a), a negative power input (16b) and a gate (38);
a gate driver circuit (18) for receiving a gate signal (V_{S}) from a gate signal input (28) and for connecting the gate (38) of the power semiconductor switch (14) with a positive voltage reference (+V_{G}) from a positive voltage reference input (26);
where the gate driver circuit (18) is further adapted for connecting the gate (38) of the power semiconductor switch (14) with a negative voltage reference (-VG) from a negative voltage reference input (32);
a common mode coupling device (20) for providing an impedance for a common mode current through auxiliary inputs of the power semiconductor unit (12), the auxiliary inputs comprising the gate signal input (28), the positive voltage reference input (26), the negative voltage reference input (32), a positive power reference input (58) connected with the positive power input (16a) and a negative power reference input (30) connected with the negative power input (16b) ;
wherein the common mode coupling device (20) comprises a common mode choke with a single core (36) coupling the auxiliary inputs (26, 28, 30, 32, 58).

2. The power semiconductor unit (12) of claim 1,
wherein the common mode coupling device (20) is interconnected between the auxiliary inputs (26, 28, 30, 32, 58) and an amplifier (22) for connecting the gate (38) of the power semiconductor switch (14) with the positive voltage reference.

3. The power semiconductor unit (12) of one of the previous claims,
wherein the gate driver circuit (18) comprises at least one gate resistor (40, 44) interconnected between an amplifier (22) for receiving the gate signal and for supplying a gate (38) of the power semiconductor switch (14).

4. The power semiconductor unit (12) of one of the previous claims,
wherein an amplifier (22) of the gate driver circuit (18) for receiving the gate signal and for supplying a gate (38) of the power semiconductor switch (14) is adapted for controlling a current supplied to a gate (38) of the power semiconductor switch (14).

5. The power semiconductor unit (12) of one of the previous claims,
wherein the gate driver circuit (18) comprises a controller reference resistor (46) interconnected between a negative power reference input (30) and the negative power input (16b) of the power semiconductor switch (14).

6. A power semiconductor unit arrangement (10), comprising:
at least two power semiconductor units (12) according to one of the previous claims,
wherein the positive and negative power inputs (16a, 16b) of the at least two power semiconductor units (12) are connected in parallel with each other.

7. The power semiconductor unit arrangement (10) of claim 6,
wherein the gate signal inputs (28) of the at least two power semiconductor units (12) are connected with each other.

8. The power semiconductor unit arrangement (10) of claim 6,
wherein the gate signal inputs (28) are connected to one or more controllers (56) adapted for generating gate signals for the at least two power semiconductor units (12), which gate signals (V_{S}) are time-shifted with respect to each other.

9. The power semiconductor unit arrangement (10) of one of claims 6 to 8,
wherein the positive voltage reference inputs (58) of the at least two power semiconductor units (12) are connected with each other;
wherein the negative power reference inputs (30) of the at least two power semiconductor units (12) are connected with each other.

## Patentansprüche

1. Leistungshalbleitereinheit (12), die Folgendes umfasst:
einen Leistungshalbleiterschalter (14), der dafür ausgelegt ist, einen Strom durch die Leistungshalbleitereinheit (12) zu schalten, wobei der Leistungshalbleiterschalter einen positiven Leistungseingang (16a), einen negativen Leistungseingang (16b) und ein Gate (38) besitzt;
eine Gate-Ansteuerschaltung (18) zum Empfangen eines Gate-Signals (V_{S}) von einem Gate-Signaleingang (28) und zum Verbinden des Gates (38) des Leistungshalbleiterschalters (14) mit einer positiven Referenzspannung (+V_{G}) von einem positiven Referenzspannungseingang (26);
wobei die Gate-Ansteuerschaltung (18) ferner dafür ausgelegt ist, das Gate (38) des Leistungshalbleiterschalters (14) mit einer negativen Referenzspannung (-V_{G}) von einem negativen Referenzspannungseingang (32) zu verbinden;
eine Gleichtakt-Kopplungsvorrichtung (20) zum Bereitstellen einer Impedanz für einen Gleichtaktstrom über Hilfseingänge der Leistungshalbleitereinheit (12), wobei die Hilfseingänge den Gate-Signaleingang (28), den positiven Referenzspannungseingang (26), den negativen Referenzspannungseingang (32), einen positiven Referenzleistungseingang (58), der mit dem positiven Leistungseingang (16a) verbunden ist, und einen negativen Referenzleistungseingang (30), der mit dem negativen Leistungseingang (16b) verbunden ist, umfassen;
wobei die Gleichtakt-Kopplungsvorrichtung (20) eine Gleichtakt-Drosselspule mit einem einzigen Kern (36), der die Hilfseingänge (26, 28, 30, 32, 58) koppelt, umfasst.

2. Leistungshalbleitereinheit (12) nach Anspruch 1,
wobei die Gleichtakt-Kopplungsvorrichtung (20) zwischen die Hilfseingänge (26, 28, 30, 32, 58) und einen Verstärker (22) geschaltet ist, um das Gate (38) des Leistungshalbleiterschalters (14) mit der positiven Referenzspannung zu verbinden.

3. Leistungshalbleitereinheit (12) nach einem der vorhergehenden Ansprüche,
wobei die Gate-Ansteuerschaltung (18) zum Empfangen des Gate-Signals und zum Versorgen eines Gates (38) des Leistungshalbleiterschalters (14) wenigstens einen Gate-Widerstand (40, 44) umfasst, der zwischen einen Verstärker (22) geschaltet ist.

4. Leitungshalbleitereinheit (12) nach einem der vorhergehenden Ansprüche,
wobei ein Verstärker (22) der Gate-Ansteuerschaltung (18) zum Empfangen des Gate-Signals und zum Versorgen eines Gates (38) des Leistungshalbleiterschalters (14) dafür ausgelegt ist, einen an das Gate (38) des Leistungshalbleiterschalters (14) gelieferten Strom zu steuern.

5. Leistungshalbleitereinheit (12) nach einem der vorhergehenden Ansprüche,
wobei die Gate-Ansteuerschaltung (18) einen Steuereinheit-Referenzwiderstand (46) enthält, der zwischen einen negativen Referenzleistungseingang (30) und den negativen Leistungseingang (16b) des Leistungshalbleiterschalters (14) geschaltet ist.

6. Leistungshalbleitereinheit-Anordnung (10), die Folgendes umfasst:
wenigstens zwei Leistungshalbleitereinheiten (12) nach einem der vorhergehenden Ansprüche,
wobei der positive und der negative Leistungseingang (16a, 16b) der wenigstens zwei Leistungshalbleitereinheiten (12) zueinander parallel geschaltet sind.

7. Leistungshalbleitereinheit-Anordnung (10) nach Anspruch 6,
wobei die Gate-Signaleingänge (28) der wenigstens zwei Leistungshalbleitereinheiten (12) miteinander verbunden sind.

8. Leistungshalbleitereinheit-Anordnung (10) nach Anspruch 6,
wobei die Gate-Signaleingänge (28) mit einer oder mehreren Steuereinheiten (56) verbunden sind, die dafür ausgelegt ist, Gate-Signale für die wenigstens zwei Leistungshalbleitereinheiten (12) zu erzeugen, wobei die Gate-Signale (Vₛ) relativ zueinander zeitlich verschoben sind.

9. Leistungshalbleitereinheit-Anordnung (10) nach einem der Ansprüche 6 bis 8,
wobei die positiven Referenzspannungseingänge (58) der wenigstens zwei Leistungshalbleitereinheiten (12) miteinander verbunden sind; und
wobei die negativen Referenzleistungseingänge (30) der wenigstens zwei Leistungshalbleitereinheiten (12) miteinander verbunden sind.

## Revendications

1. Unité semi-conductrice de puissance (12), comprenant :
un commutateur à semi-conducteur de puissance (14) conçu pour commuter un courant à travers l'unité semi-conductrice de puissance (12), le commutateur à semi-conducteur de puissance comprenant une entrée de puissance positive (16a), une entrée de puissance négative (16b) et une grille (38) ;
un pilote de grille (18) destiné à recevoir un signal de grille (Vₛ) à partir d'une entrée de signal de grille (28) et à connecter la grille (38) du commutateur à semi-conducteur de puissance (14) à une référence de tension positive (+V_{G}) provenant d'une entrée de référence de tension positive (26) ; le pilote de grille (18) étant adapté en outre pour connecter la grille (38) du commutateur à semi-conducteur de puissance (14) à une référence de tension négative (-VG) provenant d'une entrée de référence de tension négative (32) ;
un dispositif de couplage de mode commun (20) destiné à fournir une impédance pour un courant de mode commun à travers des entrées auxiliaires de l'unité semi-conductrice de puissance (12), les entrées auxiliaires comprenant l'entrée de signal de grille (28), l'entrée de référence de tension positive (26), l'entrée de référence de puissance négative (32), une entrée de référence de puissance positive (58) connectée à l'entrée de puissance positive (16a) et une entrée de référence de puissance négative (30) connectée à l'entrée de puissance négative (16b) ;
dans lequel le dispositif de couplage de mode commun (20) comprend une bobine d'arrêt de mode commun à noyau unique (36) qui couple les entrées auxiliaires (26, 28, 30, 32, 58).

2. Unité semi-conductrice de puissance (12) selon la revendication 1,
dans lequel le dispositif de couplage de mode commun (20) est interconnecté entre les entrées auxiliaires (26, 28, 30, 32, 58) et un amplificateur (22) pour connecter la grille (38) du commutateur à semi-conducteur de puissance (14) à la référence de tension positive.

3. Unité semi-conductrice de puissance (12) selon l'une des revendications précédentes,
dans laquelle le pilote de grille (18) comprend au moins une résistance de grille (40, 44) interconnectée entre un amplificateur (22) destiné à recevoir le signal de grille et à alimenter une grille (38) du commutateur à semi-conducteur de puissance (14).

4. Unité semi-conductrice de puissance (12) selon l'une des revendications précédentes,
dans laquelle un amplificateur (22) du pilote de grille (18) destiné à recevoir le signal de grille et à alimenter une grille (38) du commutateur à semi-conducteur de puissance (14) est adapté pour commander un courant fourni à une grille (38) du commutateur à semi-conducteur de puissance (14).

5. Unité semi-conductrice de puissance (12) selon l'une des revendications précédentes,
dans laquelle le pilote de grille (18) comprend une résistance de référence de contrôleur (46) interconnectée entre une entrée de référence de puissance négative (30) et l'entrée de puissance négative (16b) du commutateur à semi-conducteur de puissance (14).

6. Agencement d'unités semi-conductrices de puissance (10), comprenant :
au moins deux unités semi-conductrices de puissance (12) selon l'une des revendications précédentes, les entrées de puissance positive et négative (16a, 16b) des au moins deux unités semi-conductrices de puissance (12) étant connectées en parallèle les unes aux autres.

7. Agencement d'unités semi-conductrices de puissance (10) selon la revendication 6,
dans laquelle les entrées de signal de grille (28) des au moins deux unités semi-conductrices de puissance (12) sont connectés les unes aux autres.

8. Agencement d'unités semi-conductrices de puissance (10) selon la revendication 6,
dans lequel les entrées de signal de grille (28) sont connectées à un ou plusieurs contrôleurs (56) conçus pour générer des signaux de grille pour les au moins deux unités semi-conductrices de puissance (12), lesquels signaux de grille (Vₛ) sont décalés dans le temps les uns par rapport aux autres.

9. Agencement d'unités semi-conductrices de puissance (10) selon l'une des revendications 6 à 8,
dans lequel les entrées de référence de tension positive (58) des au moins deux unités semi-conductrices de puissance (12) sont connectées les unes aux autres ;
dans lequel les entrées de référence de puissance négative (30) des au moins deux unités semi-conductrices de puissance (12) sont connectées les unes aux autres.
